## Europäisches Patentamt

## European Patent Office

## Office européen des brevets

(11) Veröffentlichungsnummer: **0 368 433**
**A1**

# (12) EUROPÄISCHE PATENTANMELDUNG

(21) Anmeldenummer: **89250080.2**

(22) Anmeldetag: **09.11.89**

(51) Int. Cl.⁵: **F16B 5/02, H05K 5/00**

(30) Priorität: **11.11.88 DE 3838777**

(43) Veröffentlichungstag der Anmeldung:
**16.05.90 Patentblatt 90/20**

(84) Benannte Vertragsstaaten:
**AT BE CH DE ES FR GB IT LI LU NL SE**

(71) Anmelder: **MANNESMANN Aktiengesellschaft**
**Mannesmannufer 2**
**D-4000 Düsseldorf 1(DE)**

(72) Erfinder: **Stellmach, Dieter**
**Königsberger Strasse 36**
**D-7737 Bad Dürrheim(DE)**

(74) Vertreter: **Presting, Hans-Joachim et al**
**Herbertstrasse 22**
**D-1000 Berlin 33(DE)**

(54) **Lösbare Verbindung für dünnwandige, ebene, als Wand-, Decken- oder Bodenteile bzw. Seitenteile dienende Flächenbauteile.**

(57) Eine lösbare Verbindung für dünnwandige, ebene, als Wand-, Decken- oder Bodenteile bzw. Seitenteile dienende Flächenbauteile (1,2), die paarweise zueinander senkrecht verlaufen, insbesondere für Rahmenteile in Peripheriegeräten der elektronischen Datenverarbeitung, bei der ein erstes Flächenbauteil (1) mit zumindest einer Ausnehmung (3) versehen ist, in die eine Gewindeschraube (6) hineinragt, erfordert erheblich weniger Einzelteile und gleichzeitig während der Montage weniger Arbeitsgänge und wird dadurch erheblich kostengünstiger, indem ein zweites Flächenbauteil (2) mit konturierten, in der Flächenbauteilebene (5) liegenden Vorsprüngen (4) versehen ist, die in tolerierte Schlitzöffnungen (3a) des ersten Flächenbauteils (1) eingreifen und indem in dem ersten Flächenbauteil (1) Durchlässe (8) für Gewindeschrauben (6) und diesen, auf der Durchlaßachse (9) gegenüberliegend im zweiten Flächenbauteil (2) ein in seiner lichten Weite (11) für eine Selbstschneidende Gewindeschraube (6) und entsprechende Einschublänge (14) der selbstschneidenden Gewindeschraube (6) dimensionierter Ausschnitt (10) vorgesehen sind.

FIG. 1

## Lösbare Verbindung für dünnwandige, ebene, als Wand-, Decken- oder Bodenteile bzw. Seitenteile dienende Flächenbauteile

Die Erfindung betrifft eine lösbare Verbindung für dünnwandige, ebene, als Wand-, Decken oder Bodenteile bzw. Seitenteile dienende Flächenbauteile, die paarweise zueinander senkrecht verlaufen, insbesondere für Rahmenteile in Peripheriegeräten der elektronischen Datenverarbeitung, bei der ein erstes Flächenbauteil mit zumindest einer Ausnehmung versehen ist, in die eine Gewindeschraube hineinragt.

Lösbare Verbindungen derartiger Flächenbauteile, die paarweise rechtwinklig zueinander verlaufen, werden bisher als sog. Schlitzmutter-Verbindungen ausgeführt (DE-GM 18 28 856).

Außerdem ist eine solche Verbindung für dünnwandige Flächenbauteile aus der DE-PS 35 39 505 bekannt. Die erste der beiden bekannten Lösungen enthält eine speziell geformte Schlitzmutter, die nach dem Einlegen in den Schlitz eines der beiden Flächenbauteile in einem separaten Arbeitsgang verstemmt werden muß, um zu verhindern, daß die Schlitzmutter bei der Handhabung der Teile während der Montage nicht herausfällt.

Die zweite bekannte Lösung erfordert ein zusätzliches elastisches Kunststoff- oder Metallteil , das mit einem Paar von Rastnasen versehen sein muß, so daß für diese bekannte Lösung das Kunststoffteil, eine passende Sechskantmutter, sowie eine Schraube und noch eine Unterlegscheibe erforderlich werden. Die beiden bekannten Lösungen sind daher vom Aufwand her gesehen sowie bei der Montage relativ aufwendig.

Die bekannten Lösungen sind daher kostenintensiv.

Der Erfindung liegt demgegenüber die Aufgabe zugrunde, eine lösbare Verbindung für rechtwinklig zueinander angeordnete Flächenbauteile zu schaffen, die erheblich weniger Einzelteile und gleichzeitig während der Montage weniger Arbeitsgänge erfordert und dadurch erheblich kostengünstiger wird.

Die gestellte Aufgabe wird erfindungsgemäß dadurch gelöst, daß ein zweites Flächenbauteil mit konturierten, in der Flächenbauteilebene liegenden Vorsprüngen versehen ist, die in tolerierte Schlitzöffnungen des ersten Flächenbauteils eingreifen und daß in dem ersten Flächenbauteil Durchlässe für Gewindeschrauben und diesen auf der Durchlaßachse gegenüberliegend im zweiten Flächenbauteil ein in seiner lichten Weite für eine selbstschneidende Gewindeschraube und entsprechend der Einschublänge der Selbstschneidenden Gewindeschraube dimensionierter Ausschnitt vorgesehen sind. Neben den beiden Flächenbauteilen besteht diese lösbare Verbindung praktisch nur noch aus den kostengünstig herstellbaren Ausnehmungen, Vorsprüngen und Schlitzöffnungen, wobei die selbstschneidende Gewindeschraube praktisch nur noch zur endgültigen Absicherung der Verbindung dient. Eine solche lösbare Verbindung ist erheblich kostengünstiger gegenüber den bekannten herstellbar und zu montieren.

In Ausgestaltung der Erfindung ist vorgesehen, daß bei einem im Umriß polygonal geformten zweiten Flächenbauteil zumindest eine in dem ersten Flächenbauteil verlaufende und in Einsteckrichtung parallel zur Oberfläche einseitig offene, erste Ausnehmung vorgesehen ist, in die ein Vorsprung des zweiten Flächenbauteils einsteckbar ist. Diese Lösung gestattet z.B. vorteilhaft, winkelförmig gebogene Erstflächenbauteile mit Seitenwänden zu versehen.

In Weiterbildung der Erfindung ist vorgesehen, daß dem einsteckbaren Vorsprung des zweiten Flächenbauteils eine ebenfalls mit einer der Dicke des zweiten Flächenbauteils entsprechende ebenfalls einseitig offene, zweite Ausnehmung im ersten Flächenbauteil zugeordnet ist, wobei die Ausnehmungen unter einem(spitzen)Winkel zueinander verlaufen. Diese zweite Ausnehmung bildet praktisch eine Verriegelung des zweiten Flächenbauteils am ersten Flächenbauteil schon nach der Montage, so daß das Einsetzen der selbstschneidenden Gewindeschraube eine zusätzliche Sicherung der Verbindung darstellt.

Ein Ausführungsbeispiel der Erfindung ist in der Zeichnung dargestellt und wird im folgenden näher beschrieben. Es zeigen

Fig. 1 einen senkrechten Querschnitt durch die lösbare Verbindung,

Fig. 2 eine Draufsicht zu Fig. 1, jedoch ohne die selbstschneidende Gewindeschraube gezeichnet,

Fig. 3 den senkrechten Querschnitt gemäß Fig. 1, ebenfalls ohne die selbstschneidende Gewindeschraube und

Fig. 4 eine Seitenansicht eines praktischen Ausführungsbeispiels einer Flächenbauteil-Verbindung für einen Computer-Drucker.

Die lösbare Verbindung ist für ein erstes Flächenbauteil 1 gestaltet, das zu einem zweiten Flächenbauteil 2 senkrecht steht. Beide Flächenbauteile 1 und 2 sind relativ dünnwandig (ca. 1 mm dick), im Bereich ihrer Verbindung eben und dienen als Wand-, Decken- oder Bodenteile bzw. als Seitenteile, vorzugsweise in einem Peripheriegerät der EDV-Technik. Derartige Rahmenteile werden z.B. in Druckern verwendet.

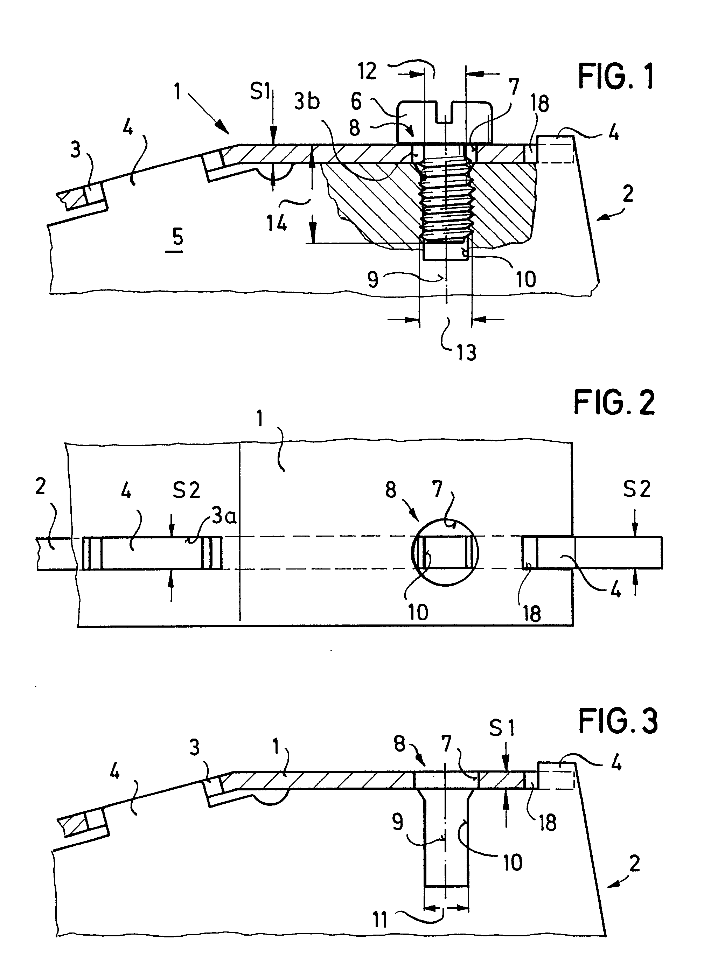

Das erste Flächenbauteil 1 weist zumindest eine Ausnehmung 3 auf, in die ein Vorsprung 4 des zweiten Flächenbauteils 2 ragt. Der Vorsprung 4, von dem mehrere in einer Ebene liegend vorhanden sind, liegt jeweils in der Flächenbauteilebene 5 des zweiten Flächenbauteils 2. Die Ausnehmungen 3 bilden tolerierte Schlitzöffnungen 3a (Fig. 2), in die die Vorsprünge 4, die z.B. Rechteckquerschnitt aufweisen, passen. Im Bereich von Gewindeschrauben 6 kann die Schlitzöffnung 3a auch als Erweiterung 3b anstelle einer runden Bohrung 7 gestaltet sein, so daß die Ausnehmungen 3, die tolerierten Schlitzöffnungen 3a und die Erweiterungen 3b gleichzeitig durch Stanzen erzeugt werden können. Unter den Bohrungen 7 und den Erweiterungen 3b sind daher allgemein Durchlässe 8 zu verstehen.

Auf der Durchlaßachse 9 liegt dem ersten Flächenbauteil gegenüber ein Ausschnitt 10, der in seiner lichten Weite 11 dem Kerndurchmesser 12 (Fig. 1) der Gewindeschraube 6 entspricht. Bei weichem Werkstoff der Flächenbauteile 1 und 2, die gewöhnlich aus Stahlblech bestehen, wird die lichte Weite 11 bis 0,95 mal Gewinde-Nenndurchmesser 13 gewählt. Die Einschraublänge 14 der Gewindeschraube 6 richtet sich je nach Beanspruchung der Verbindung. In der Praxis bewährt sich eine Einschraublänge, die dem einfachen Gewinde-Nenndurchmesser 13 bis dem Doppelten des Gewinde-Nenndurchmessers 13 entspricht, wobei der doppelte Gewinde-Nenndurchmesser 13 für sehr hoch beanspruchte Verbindungen bzw. für weiche Werkstoffe der Flächenbauteile 1 und 2 gewählt wird.

Die Dicken S1 und S2 der beiden Flächenbauteile 1 und 2 richten sich nach den konstruktiven Erfordernissen eines Gerätes.

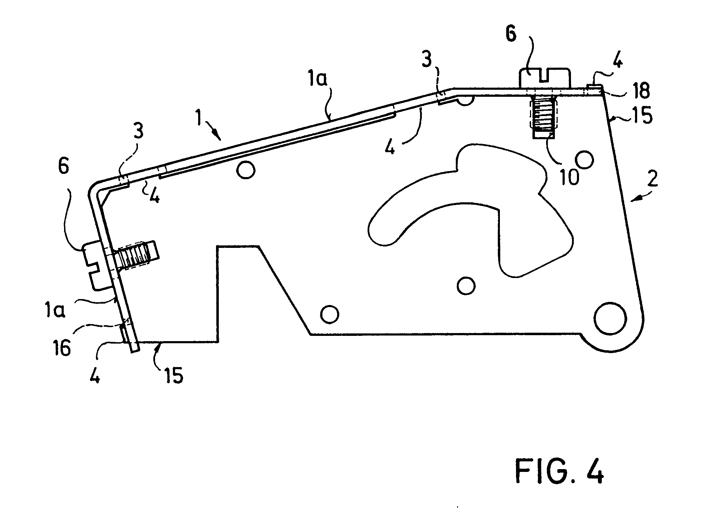

Bei im Umriß 15 (Fig. 4) polygonal geformtem Flächenbauteil 2 ergibt sich ein formanalog gebogener Flächenbauteil 1. Hier wird quer zur Oberfläche 1a des ersten Flächenbauteils 1 eine einseitig offene, erste Ausnehmung 16 gebildet, in die mit ihrem Vorsprung 4 in das zweite Flächenbauteil 2 eingesteckt wird. Das erste Flächenbauteil 1 kann ebenfalls mit einer der Dicke S2 des zweiten Flächenbauteils 2 entsprechenden einseitig offenen, zweiten Ausnehmung 18 versehen sein, wobei die Ausnehmungen 16 und 18 unter dem gezeichneten(spitzen)Winkel zueinander verlaufen.

## Ansprüche

1. Lösbare Verbindung für dünnwandige, ebene, als Wand-, Decken- oder Bodenteile bzw. Seitenteile dienende Flächenbauteile, die paarweise zueinander senkrecht verlaufen, insbesondere für Rahmenteile in Peripheriegeräten der elektronischen Datenverarbeitung, bei der ein erstes Flächenbauteil mit zumindest einer Ausnehmung versehen ist, in die eine Gewindeschraube hineinragt, dadurch gekennzeichnet, daß ein zweites Flächenbauteil (2) mit konturierten, in der Flächenbauteilebene (5) liegenden Vorsprüngen (4) versehen ist, die in tolerierte Schlitzöffnungen (3a) des ersten Flächenbauteils (1) eingreifen und daß in dem ersten Flächenbauteil (1) Durchlässe (8) für Gewindeschrauben (6) und diesen, auf der Durchlaßachse (9) gegenüberliegend im zweiten Flächenbauteil (2) ein in seiner lichten Weite (11) für eine selbstschneidende Gewindeschraube (6) und entsprechend der Einschublänge (14) der selbstschneidenden Gewindeschraube (6) dimensionierter Ausschnitt (10) vorgesehen sind.

2. Lösbare Verbindung nach Anspruch 1, dadurch gekennzeichnet, daß bei einem im Umriß (15) polygonal geformten zweiten Flächenbauteil (2) zumindest eine in dem ersten Flächenbauteil (1) verlaufende und in Einsteckrichtung parallel zur Oberfläche (1a) einseitig offene erste Ausnehmung (16) vorgesehen ist, in die ein Vorsprung (4) des zweiten Flächenbauteils (2) einsteckbar ist.

3. Lösbare Verbindung nach den Ansprüchen 1 oder 2, dadurch gekennzeichnet, daß dem einsteckbaren Vorsprung (4) des zweiten Flächenbauteils (2) eine ebenfalls mit einer der Dicke (S2) des zweiten Flächenbauteils (2) entsprechende, ebenfalls einseitig offene, zweite Ausnehmung (18) im ersten Flächenbauteil (1) zugeordnet ist, wobei die Ausnehmungen (16, 18) unter einem Winkel zueinander verlaufen.

FIG. 1

FIG. 2

FIG. 3

FIG. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 116 510 (H.D. FRANCO) <br> * Spalte 2, Zeile 16 - Spalte 4, Zeile 17; Figuren 1-7 * <br> --- | 1-3 | F 16 B 5/02 <br> H 05 K 5/00 |
| A | FR-A- 895 749 (OLYMPIA BÜROMASCHINENWERK A.G.) <br> * Seite 2, Zeilen 13-64; Figuren 1-7 * <br> --- | 1-3 | |
| D,A | DE-A-3 539 505 (GOMOLL, GÜNTER) <br> --- | | |
| D,A | DE-U-1 828 856 (KODAK A.G.) <br> ----- | | |

**RECHERCHIERTE SACHGEBIETE (Int. Cl.5)**

F 16 B
H 05 K

Der vorliegende Recherchenbericht wurde für alle Patentansprüche erstellt

| Recherchenort | Abschlußdatum der Recherche | Prüfer |
|---|---|---|
| DEN HAAG | 16-02-1990 | ARESO Y SALINAS J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument